Europäisches Patentamt

European Patent Office

Office européen des brevets

(11) Numéro de publication: **0 034 982**
**B1**

(12) **FASCICULE DE BREVET EUROPEEN**

(45) Date de publication du fascicule du brevet: **15.02.84**

(21) Numéro de dépôt: **81400250.7**

(22) Date de dépôt: **18.02.81**

(51) Int. Cl.³: **C 30 B 11/00,**
**C 30 B 29/48,**
**H 01 L 31/18,**
**H 01 L 29/221,**
**C 30 B 19/00**

(54) Procédé de préparation de couches homogènes de Hg1-xCdxTe.

(30) Priorité: **22.02.80 FR 8004015**

(43) Date de publication de la demande:
**02.09.81 Bulletin 81/35**

(45) Mention de la délivrance du brevet:
**15.02.84 Bulletin 84/7**

(84) Etats contractants désignés:
**DE GB NL**

(56) Documents cités:
**US - A - 3 622 405**

**JOURNAL OF THE ELECTROCHEMICAL SOCIETY, vol. 125, no. 2, février 1978, G. FIORITO et al.: "A Possible Method for the Growth of Homogeneous Mercury Cadmium Telluride Single Crystals", pages 315-317 APPLIED PHYSICS LETTERS, vol. 34, no. 1, janvier 1979, US, M. LANIR et al.: "Backside-illuminated HgCdTe/CdTe photodiodes", pages 50-52**

(73) Titulaire: **SOCIETE ANONYME DE TELECOMMUNICATIONS**
**40 avenue de New York**
**F-75116 Paris (FR)**

(72) Inventeur: **Durand, Alain**
**12, 14 rue du Général Niox**
**F-75016 Paris (FR)**

(74) Mandataire: **Bloch, Robert et al,**
**Cabinet ROBERT BLOCH 39 avenue de Friedland**
**F-75008 Paris (FR)**

Courier Press, Leamington Spa, England.

Procédé de préparation de couches homogènes de $Hg_{1-x}Cd_xTe$

La présente invention concerne un procédé de préparation de couches de composition $Hg_{1-x}Cd_xTe$ réalisées sur substrat de CdTe, permettant d'obtenir une couche de $Hg_{1-x}Cd_xTe$ d'une très grande homogénéité interne et une transition abrupte avec le substrat de CdTe.

L'alliage $Hg_{1-x}Cd_xTe$ peut être considéré comme un mélange dans des proportions définies par la valeur de x de HgTe et CdTe, et sa largeur de bande interdite varie en fonction de x à partir d'une valeur $Eg = 1,6$ eV pour CdTe à 77°K. Pour $x = 0,20$, la largeur de bande est d'environ 0,1 eV à 77°K et le domaine de sensibilité spectrale correspondant se situe entre 8 et 14 $\mu$m.

Il doit être entendu que la valeur de x dont il est question ici définit la composition à la surface opposée au substrat, la proportion de cadmium augmentant de x jusqu'à 1 à mesure que l'on s'éloigne de la surface extérieure.

Les couches épitaxiées de $Hg_{1-x}Cd_xTe$ sont obtenues de façon appropriée par la technique EDRI (Evaporation Diffusion en Régime Isotherme) décrite dans le brevet français FR—A—1 447 257. Ce procédé consiste à placer face à face une plaquette de CdTe et une plaquette de HgTe à l'intérieur d'une enceinte sous vide et à porter la température à une valeur élevée constante, généralement comprise entre 500 et 600°C. Ce procédé donne, dans le cas de couches minces, une composition superficielle x insuffisante pour les besoins car au plus égale à 0,10—0,15.

Pour obtenir la valeur de x souhaitée, par exemple $x = 0,20$, il a été proposé dans le brevet US—A—3 725 135 d'établir dans l'enceinte de traitement une pression de mercure en excès en introduisant dans l'enceinte une certaine quantité de mercure.

Ce procédé ne procure cependant qu'une homogénéité interne médiocre. En d'autres termes, le gradient $\Delta x/\Delta e$ au voisinage de la surface, e étant l'épaisseur de la couche, est trop important. Cela empêche d'utiliser ensuite les techniques applicables aux matériaux massifs.

De plus, la transition entre la zone superficielle de composition $Hg_{1-x}Cd_xTe$ et le substrat de CdTe est très progressive, d'où il résulte la présence d'une zone intermédiaire d'épaisseur importante dans laquelle la proportion x de cadmium augmente progressivement jusqu'à la valeur $x = 1$.

Ceci présente l'inconvénient qu'il n'est pas possible d'utiliser la face côté substrat en tant que face exposée au rayonnement, car la partie de la zone intermédiaire adjacente à la zone superficielle présente une composition et donc une largeur de bande interdite, voisines de celles de la zone superficielle.

En cas d'éclairement de la face côté substrat, les photons dont la longueur d'onde se situe dans le domaine spectral envisagé — par exemple 8—14$\mu$m — traverseraient le substrat, celui-ci ayant une largeur de bande interdite importante, mais seraient absorbés par la zone intermédiaire avant d'atteindre la zone superficielle.

Or il serait intéressant d'éclairer la face côté substrat pour plusieurs raisons. En particulier, comme les connexions électriques nécessaires pour recueillir le courant doivent être placées sur la face opposée au substrat, à proximité de la jonction pn, la face portant les connexions ne serait pas exposée au rayonnement. Cela permettrait de réduire la surface des jonctions et donc d'augmenter la densité des points actifs. En outre il deviendrait possible de réaliser le substrat sous forme de lentille concentrant le rayonnement.

Mais l'éclairement de la face côté substrat n'est envisageable que si l'on parvient à réduire très sensiblement l'absorption des photons par la zone intermédiaire, donc l'épaisseur de celle-ci.

L'invention vise par conséquent à réaliser des couches minces épitaxiées de $Hg_{1-x}Cd_xTe$ sur substrat de CdTe présentant une excellente homogénéité interne de la couche superficielle de $Hg_{1-x}Cd_xTe$ et une transition abrupte entre la couche superficielle et le substrat, donc une très faible épaisseur de la zone intermédiaire.

Pour atteindre ces buts, l'invention prévoit de déposer par croissance épitaxique une couche de composition superficielle $Hg_{1-xo}Cd_{xo}Te$ sur un substrat de CdTe, xo étant inférieur à la valeur souhaitée x, de soumettre la couche à un traitement de fusion à une température comprise dans la plage de fusion de la composition à obtenir, puis de refroidin rapidement la couche.

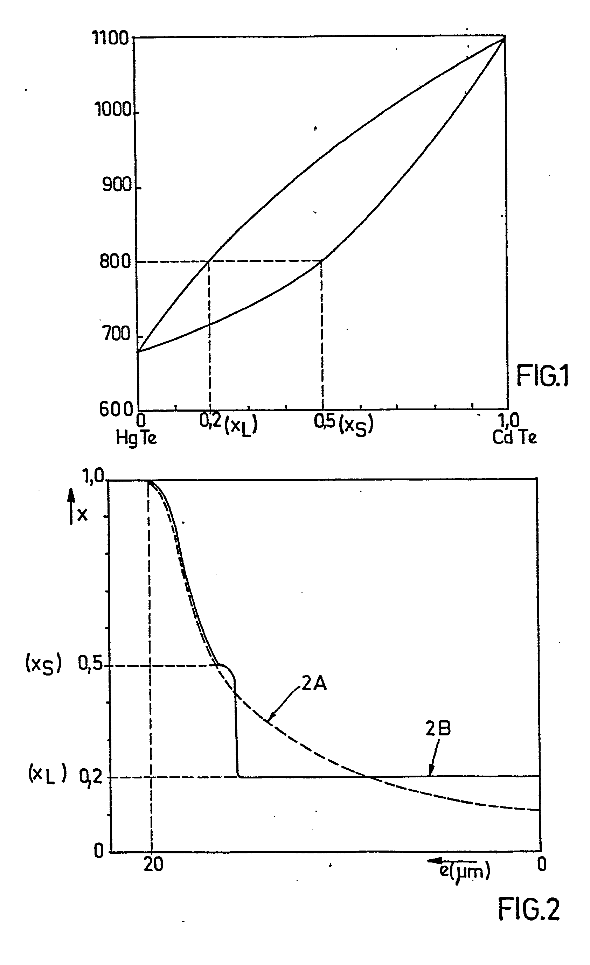

L'invention repose sur le fait qu'à une température donnée T comprise dans la plage de fusion, il existe une différence de composition entre le $Hg_{1-x}Cd_xTe$ à l'état liquide et le $Hg_{1-x}Cd_xTe$ à l'état solide. Comme cela ressort du diagramme de phases annexé (Fig. 1), on trouve à l'équilibre une phase liquide de composition $x_L$ et une phase solide de composition $x_S$, aucune composition intermédiaire entre $x_L$ et $x_S$ ne pouvant exister.

Si l'on soumet à la fusion une plaquette dont le profil est tel que représenté à la figure 2 et qui comprend une zone superficielle de composition inférieure à $x_L$, une zone intermédiaire de composition comprise entre $x_L$ et $x_S$ et une zone de composition supérieure à $x_S$, la zone superficielle ($x < x_L$) passe à l'état liquide, la zone côté substrat ($x > x_S$) reste à l'état solide, et la zone intermédiaire ($x_L < x < x_S$) se scinde en une partie liquide et une partie solide. Le refroidissement fige cette situation et la phase liquide une fois solidifiée présente une composition homogène x qui est la moyenne des compositions de départ dans les zones devenant liquides lors de la fusion. On obtient ainsi un gradient $\Delta x/\Delta e$ pratiquement nul à partir de la surface dans toute la partie superficielle résultant de la solidification de la phase liquide. Par ailleurs, la partie résultant de la phase solide a une composition au moins égale à $x_S$, d'où il résulte une transition extrêmement abrupte avec la partie superficielle.

Il est facile de déterminer la température de fusion T pour un profil de composition initial donné de manière à obtenir la valeur x souhaitée, puisqu'à une température T correspondent des valeurs $x_L$ et $x_S$ bien définies.

L'invention sera bien comprise à la lecture de la description ci-après, faite en référence aux dessins annexés.

Dans les dessins:
— la figure 1 montre, comme on l'a dit, le diagramme de phases de $Hg_{1-x}Cd_xTe$;
— la figure 2 illustre à titre d'exemple le profil de composition obtenu grâce au procédé selon l'invention, dans le cas d'une couche mince;
— la figure 3 illustre un autre exemple d'application de l'invention, dans le cas d'une couche plus épaisse;
— la figure 4 représente schématiquement un agencement pour la réalisation du traitement thermique;
— la figure 5 représente, à plus grande échelle, le dispositif supportant les plaquettes; et
— la figure 6 montre l'évolution de la température lors du traitement thermique selon l'invention.

La figure 1 est le diagramme de phases de $Hg_{1-x}Cd_xTe$ qui se compose de la courbe de soidus S et de la courbe de liquidus L. On note qu'à une température donnée, par exemple à 800°C, la phase liquide a une composition $x_L = 0,2$ tandis que la phase solide a une composition $x_S = 0,5$ et qu'il n'existe pas à l'équilibre de composition intermédiaire entre $x_L$ et $x_S$.

Cette propriété est utilisée comme on va le voir pour obtenir des couches de $Hg_{1-x}Cd_xTe$ épitaxiées sur substrat de CdTe présentant une très grande homogénéité interne et une transition très abrupte avec le substrat.

Sur la figure 2, la courbe 2A en pointillé montre le profil de composition d'une couche mince de $Hg_{1-x}Cd_xTe$ déposée par croissance épitaxique sur un substrat de CdTe selon la technique EDRI évoquée plus haut. L'épaisseur de la couche est 20 $\mu$m, et la composition superficielle x est d'environ 0,13. Le procédé EDRI a été décrit en détail dans de nombreuses publications et il est inutile de détailler le mode de préparation de la couche mince de départ.

On sait que la technique EDRI donne une bonne homogénéité radiale, mais que l'homogénéité interne n'est pas bonne, en particulier dans le cas d'une couche mince, et on voit sur la courbe 2A que le gradient interne $\Delta x/\Delta e$, e étant l'épaisseur, est très élevé.

Le procédé selon l'invention consiste à porter la couche de $Hg_{1-x}Cd_xTe$ à une température T comprise dans la plage de fusion, et à refroidir ensuite rapidement.

Supposons que la température de fusion T soit 800°C. Les compositions $x_L$ et $x_S$ sont définies par le diagramme de phases de la figure 1 et égales respectivement à 0,2 et 0,5. En reportant ces valeurs sur le profil de la figure 2, on constate que l'on divise la couche de départ en trois zones: une zone superficielle où la composition est inférieure à 0,2; une zone intérieure adjacente au substrat, où la composition est supérieure à 0,5; et une zone intermédiaire où la composition est comprise entre 0,2 et 0,5.

Lorsqu'on porte la couche à la température de 800°C, il résulte du diagramme de phase que la zone superficielle devient liquide, la zone intérieure reste solide et la zone intermédiaire se scinde en une partie qui reste solide et une partie qui devient liquide. La phase liquide est évidemment homogène et sa proportion de cadmium x est la valeur moyenne de cette proportion sur la partie de la couche qui est passée à l'état liquide. Le refroidissement brusque provoque la solidification de la phase liquide, mais ne modifie pas les compositions.

Le profil final obtenu est illustré par la courbe 2B en trait plein. La zone superficielle de composition $x = 0,20$ présente un gradient interne nul. Son épaisseur est d'environ 12 $\mu$m. A la zone superficielle succède une zone de transition très abrupte, dans laquelle la composition passe de la valeur $x = 0,20$ à la valeur $x = 0,50$ sur une épaisseur de l'ordre de 1 à 2 $\mu$m. Quant à la zone interne, elle n'est pas modifiée par rapport au profil initial.

Un tel profil permet d'utiliser la plaquette ainsi obtenue pour fabriquer un détecteur infrarouge à éclairement par la face côté substrat ou face arrière. Le substrat en CdTe, dont la largeur de bande interdite est importante, est transparent aux photons ayant la longueur d'onde considérée, à savoir située dans la plage 8—14 $\mu$m, et la zone de transition, étant donné sa très faible épaisseur, n'absorbe pratiquement pas les photons. Ceux-ci ne sont absorbés que dans la zone superficielle, au niveau de la jonction pn que l'on a placée au voisinage de la zone de transition. Etant donné que la zone superficielle n'a qu'une épaisseur faible d'environ 10 $\mu$m, cela ne pose pas de problèmes.

Dans l'exemple décrit, la valeur x obtenue dans la zone superficielle et égale à 0,20 correspond à la composition $x_L$ qui résulte du diagramme de phases. Mais cette coïncidence n'est nullement une nécessité, et il ressort au contraire de ce qui précède que la valeur x obtenue peut être différente de $x_L$.

La valeur x dépend en fait du profil initial de la composition $x_0 = f(e)$ et de la température T à laquelle on effectue la fusion. La température T détermine l'épaisseur $e_L$ de la partie de la couche qui devient liquide lors de la fusion, et la valeur x est la moyenne de f(e) sur l'épaisseur

$e_L$, c'est-à-dire correspond à l'intégrale

$$\frac{1}{e_L} \int_0^{e_L} f(e)\, de$$

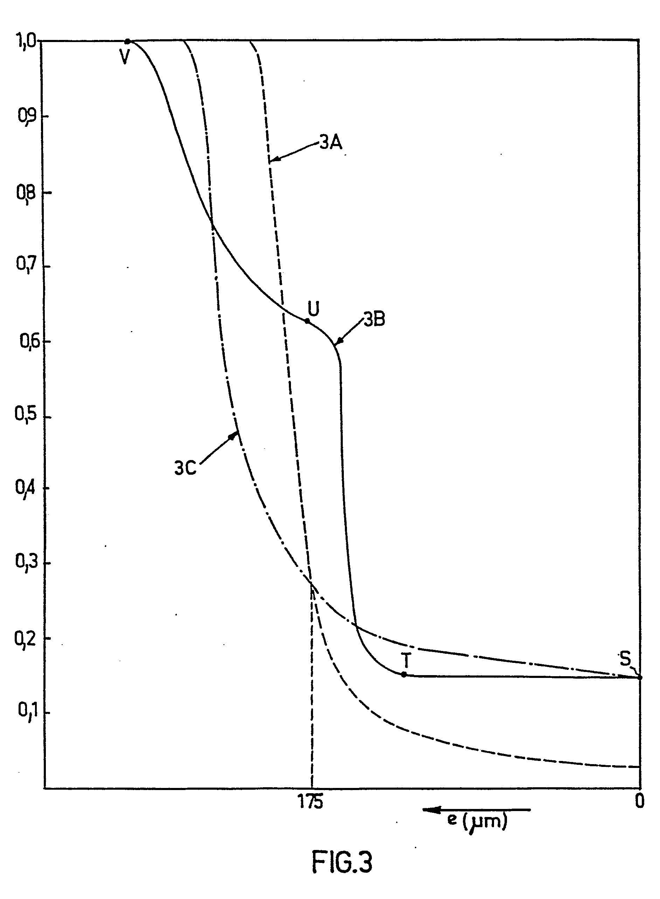

L'exemple illustré à la figure 3 concerne une couche plus épaisse. La courbe 3A en pointillé donne le profil initial d'une couche obtenue par la technique EDRI et de 175 $\mu$m d'épaisseur. La composition superficielle $x_o$ de cette couche est d'environ 0,03.

La courbe 3B en trait plein donne le profil obtenu avec le traitement selon l'invention à 800°C. La zone superficielle homogène ST a une composition $x = 0,14$—0,15 et s'étend sur environ 120 $\mu$m. A cette zone superficielle succède une première zone de transition TU très abrupte, d'environ 55 $\mu$m d'épaisseur, dans laquelle la composition passe de 0,15 à environ 0,60. Une deuxième zone de transition UV moins abrupte relie la première zone de transition au substrat.

On a également représenté sur la figure 3 une courbe 3C en trait mixte qui illustre le profil obtenu en soumettant la couche de départ à un traitement de recuit tel que décrit dans la demande de brevet français FR—A—2460545. On constate dans ce cas un gradient interne faible, mais non négligeable dans la zone superficielle puisque la composition varie de 0,05 sur environ 140 $\mu$m d'épaisseur à partir de la surface. En outre, dans la zone intermédiaire entre la zone superficielle et le substrat, la composition augmente de façon beaucoup plus progressive que dans la couche obtenue selon l'invention. Un détecteur infrarouge fabriqué à partir de cette plaquette ne pourrait donc fonctionner en étant éclairé du côté substrat.

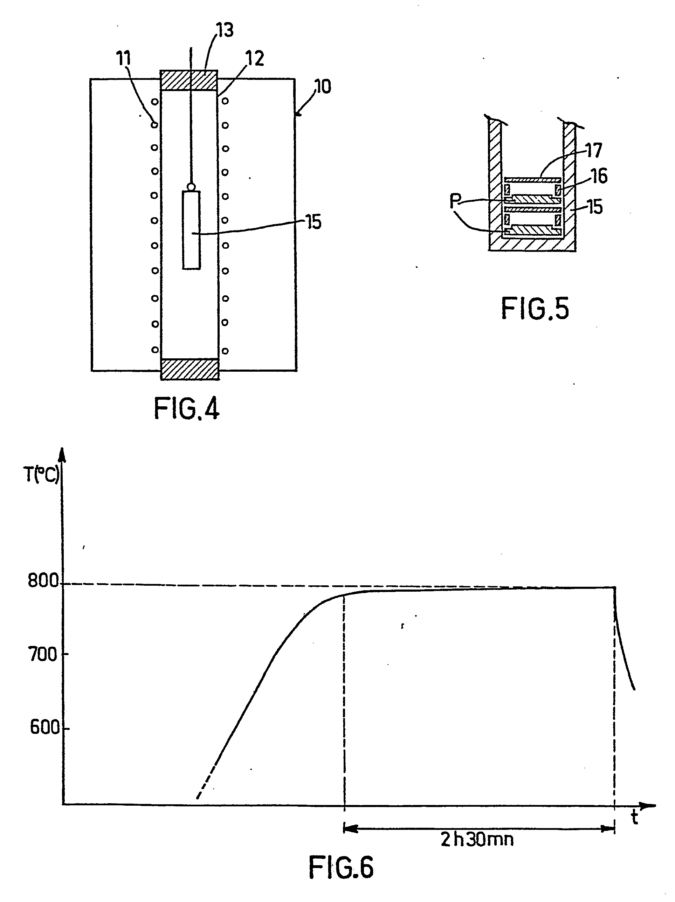

Les figures 4, 5 et 6 illustrent la réalisation pratique du traitement thermique selon l'invention. Le traitement est effectué dans un four électrique 10 (cf. figure 4). Un élément chauffant 11 entoure une enceinte 12 à l'intérieur de laquelle on suspend un tube en quartz 15 contenant les plaquettes à traiter. L'enceinte 12 est tubulaire et fermée à ses deux extrémités par des tampons 13 de matière réfractaire telle que de la laine de quartz. Le tube 15 est placé au centre du tube 12, donc dans une zone où la température est constante.

La figure 5 montre en coupe et à plus grande échelle le fond du tube 15. Les plaquettes à traiter P sont empilées à l'intérieur du tube en étant séparées par des cales annulaires 16, et des disques 17, tous ces éléments étant également en quartz.

La figure 6 montre l'évolution de la température T en fonction du temps t au cours du traitement, la température de traitement étant choisie égale à 800°C.

La phase de montée de la température dure environ 2 h 30 mn, cette durée n'étant liée qu'au fonctionnement du four. Le traitement proprement dit consiste à maintenir la température à 800°C pendant une durée d'environ 2h 30 mn. Au début de cette phase, la température est en fait très légèrement inférieure à 800°C et la valeur de 800°C n'est atteinte que vers la fin du traitement. Ensuite, on arrête le four et la température tombe très rapidement. Le profil de composition est ainsi figé dans son état à la fin de la phase de fusion.

Le traitement selon l'invention est donc très rapide puisque sa durée globale est un peu supérieure à 5 heures.

**Revendications**

1. Procédé pour obtenir une couche homogène de composition $Hg_{1-x}Cd_xTe$, caractérisé par le fait qu'on dépose par croissance épitaxique une couche de composition superficielle $Hg_{1-xo}Cd_{xo}Te$ sur un substrat de CdTe, xo étant inférieur à la valeur souhaitée x, on soumet la couche à un traitement de fusion à une température comprise dans la plage de fusion de la composition à obtenir, puis on refroidit rapidement la couche.

2. Détecteur infrarouge constitué par une plaquette obtenue par le procédé selon la revendication 1, caractérisé par le fait que la surface exposée au rayonnement est la surface du substrat, opposée à la surface de la couche de composition $Hg_{1-x}Cd_xTe$.

3. Détecteur selon la revendication 2, caractérisé par le fait qu'il comprend une jonction pn située dans la partie de la couche de $Hg_{1-x}Cd_xTe$ la plus voisine du substrat.

**Patentansprüche**

1. Verfahren zur Herstellung einer homogenen Schicht mit der Zusammensetzung $Hg_{1-x}Cd_xTe$, dadurch gekennzeichnet, daß man durch Epitaxie eine Schicht mit der Oberflächen zusammensetzung $Hg_{1-xo}Cd_{xo}Te$ auf einem CdTe-Träger ablagert, wobei xo kleiner ist als der angestrebte Wert x, daß man diese Schicht bei einer Temperatur, die innerhalb des Schmelzbereiches der zu erhaltenden Zusammensetzung liegt, einer Schmelzbehandlung unterwirft, und daß man anschließend diese Schicht schnell abkühlte.

2. Infrarotdetektor, der eine Platine umfaßt, die nach dem Verfahren gemäß Anspruch 1 hergestellt ist, dadurch gekennzeichnet, daß die der Strahlung ausgesetzte Oberfläche die Fläche des Trägers ist, die entgegengesetzt zur Oberfläche der Schicht mit der Zusammensetzung $Hg_{1-x}Cd_xTe$ liegt.

3. Detektor nach Anspruch 2, dadurch gekennzeichnet, daß er einen pn-Übergang aufweist, der sich in dem Teil der $Hg_{1-x}Cd_xTe$-Schicht befindet, der dem Träger am nächsten liegt.

**Claims**

1. A process for obtaining a homogeneous layer of composition $Hg_{1-x}Cd_xTe$, characterized in that a layer of superficial composition $Hg_{1-x_o}Cd_{x_o}Te$ is deposited by epitaxial growth on a CdTe substrate, $x_o$ being smaller than the desired value $x$, the layer is subjected to a melting treatment at a temperature comprised within the melting range of the composition to obtain, and then the wafer is rapidly cooled.

2. Infrared detector constituted by a wafer obtained by the process according to Claim 1, characterized in that the surface exposed to the radiation is the surface of the substrate opposite the surface of the layer of composition $Hg_{1-x}Cd_xTe$.

3. Detector according to Claim 2, characterized in that it comprises a pn junction located in the part of the layer of $Hg_{1-x}Cd_xTe$ closest to the substrate.

FIG.1

FIG.2

FIG.3

FIG.4

FIG.5

FIG.6